# EUROPÄISCHE PATENTSCHRIFT

(11) **EP 3 008 474 B1**
(45) Veröffentlichungstag und Bekanntmachung des Hinweises auf die Patenterteilung: **04.03.2020**
(21) Anmeldenummer: 14727835.2
(22) Anmeldetag: 04.06.2014
(51) Int. Cl.: G01R 15/18, G01R 15/20, G01R 31/02

(54) **STROMSENSORANORDNUNG MIT MESSSPULEN**
CURRENT SENSOR ARRANGEMENT WITH MEASURING COILS
SYSTÈME DE DÉTECTION DE COURANT ÉQUIPÉ DE BOBINES DE MESURE

(30) Priorität: 12.06.2013 DE 102013106100
(43) Veröffentlichungstag der Anmeldung: 20.04.2016
(73) Patentinhaber: Phoenix Contact GmbH & Co. KG, 32825 Blomberg (DE)
(72) Erfinder: SCHOLZ, Peter, 33034 Brakel (DE); SCHAPER, Elmar, 32676 Lügde (DE)
(74) Vertreter: Patentship Patentanwaltsgesellschaft mbH
(86) Internationale Anmeldenummer: PCT/EP2014/061564
(87) Internationale Veröffentlichungsnummer: WO 2014/198603

(56) Entgegenhaltungen:
- WO-A1-97/13156
- US-A- 3 312 898
- US-A1- 2002 180 417
- US-A1- 2012 146 620
- US-A1- 2013 106 412

## Beschreibung

Die Erfindung betrifft das Gebiet der induktiven Strommessung.

In Mehrphasen-Leitersystemen, beispielsweise in Dreiphasen-Leitersystemen, sind Strommessungen notwendig, um beispielsweise Kurzschlüsse zu erkennen und um einen Kurzschlussschutz für die an ein Mehrphasen-Leitersystem angeschlossenen elektrischen Lasten wie beispielsweise Motoren oder Heizelemente zu ermöglichen.

Im Rahmen des Kurzschlussschutzes wird gemäß der Norm IEC 60947-4-1 zwischen zwei Zuordnungsarten unterschieden. In der Zuordnungsart 1 dürfen beispielsweise Schütze oder Halbleiterschaltgeräte, zerstört werden, wenn von ihnen keine Gefahr wie Feuer oder durch offene spannungsführende Teile ausgeht. In der Zuordnungsart 2 müssen die nachgelagerten Geräte jedoch funktionsfähig bleiben, wobei ein Benutzereingriff, wie das Aufbrechen von Schaltkontakten mit einfachen Werkzeugen, notwendig sein kann. Während mechanische Schaltgeräte, wie beispielsweise Schütze, häufig der Zuordnungsart 2 zugeordnet sind, ist für Halbleiterschaltgeräte, beispielsweise für Motoren, meist die Zuordnungsart 1 zutreffend.

Für die Strommessung in Mehrphasen-Leitersystemen können entweder Durchsteckstromwandler, Magnetfeldsensoren oder Stromsensoren eingesetzt werden.

Als Stromsensoren können beispielsweise Rogowski-Spulen, auch als Rogowski-Stromwandler genannt, eingesetzt werden. Eine Rogowski-Spule umfasst eine torroide Messspule mit einem Luftkern. Zur Strommessung wird ein Strom führender Leiter durch die Rogowski-Spule umschlossen, wobei aufgrund des in dem Strom führenden Leiter fließenden Stroms in der Messspule eine elektrische Spannung erzeugt wird.

Bei einer Strommessung in einem Mehrphasen-Leitersystem entstehen jedoch durch die in den benachbarten Strom führenden Leitern fließenden Ströme magnetische Störfelder, welche eine Strommessung mithilfe einer konventionellen Rogowski-Spule verfälschen können. Außerdem können Rogowski-Spulen aufgrund der torroiden Spulenform nicht in Mehrphasen-Leitersystemen einsetzen, welche planar auf einer Leiterplatte angeordnet sind.

Die Druckschrift WO 97 / 13 156 A1 betrifft einen AC Stromsensor zum Detektieren eines Wechselstroms durch eine Lastimpedanz einer elektrischen Schaltung. Die Sensorkomponenten sind innerhalb eines Mehrschichtenboards gefertigt.

Die Druckschrift US 3,312,898 A betrifft eine Messvorrichtung zum Messen von Mehrphasenströmen. Diese umfasst drei induktive Messspulen, welche gegenüber dreier Leiter einer Hochspannungsübertragungsleitung angeordnet sind, und die gemessenen Ströme über drei Leitungen an drei Verstärkereinrichtungen weiterleiten.

Die Druckschrift US 2013 / 0 106 412 A1 betrifft einen elektrischen Stromsensor mit einem magnetischen Detektionselement, einer Mehrzahl von Spulen und einem Schaltkreis.

Die Druckschrift US 2002 / 180 417 A1 offenbart einen Stromsensor zum Messen eines oder mehrerer Ströme. Der Sensor umfasst mehrere leitfähige Pfade, um mehrere Ströme durch den Sensor zu leiten und mehrere Sensoren zum Erfassen mehrerer lokaler Magnetfelder, die um die mehreren Pfade herum erzeugt werden, wodurch ein Strommesswert bereitgestellt wird, der die Größe der Ströme beschreibt.

Die Druckschrift US 2012 / 146 620 A1 betrifft einen Stromsensor. Der Sensor umfasst mehrere Sätze von zwei entgegengesetzt konfigurierten Sensorelementen, die um ein Erfassungsvolumen mit einer zentralen Achse herum angeordnet sind.

Es ist daher die Aufgabe der vorliegenden Erfindung, einen verbesserten Stromsensor zu schaffen, welcher auch in einem Mehrphasen-Leitersystemen eingesetzt werden kann.

Diese Aufgabe wird durch die Merkmale der unabhängigen Ansprüche gelöst. Vorteilhafte Ausführungsformen der Erfindung sind Gegenstand der abhängigen Ansprüche, der beiliegenden Figuren und der Beschreibung.

Gemäß einem Aspekt betrifft die Erfindung eine Strommessanordnung gemäß Anspruch 1.

Die Messspulen der Messinduktivität können beispielsweise als Messspulen oder als räumlich ausgedehnte Messspulen, beispielsweise als zumindest teilweise torroide Spulen, ausgebildet sein.

Die Messspulen können ferner räumlich zusammenhängen und beispielswiese gemeinsam eine Torroidform und damit eine modifizierte Rogowski-Spule bilden.

Die Messspulen können jedoch räumlich voneinander beabstandet sein und eine Lücke bilden, welche mittels eines windungsfreien Verbindungsabschnitts überbrückt wird. Die Lücke dient zur Aufnahme eines Strom führenden Leiters, dessen Strom erfasst werden soll. Der Strom führende Leiter kreuzt somit den windungsfreien Verbindungsabschnitt, welcher oberhalb oder unterhalb des Strom führenden Leiters verläuft. Die Messinduktivität kann gemäß einer Ausführungsform somit als eine modifizierte Rogowski-Spule interpretiert werden.

Gemäß einer Ausführungsform weisen die erste Messspule und die zweite Messspule unterschiedliche Induktivitäten, unterschiedliche Windungszahlen, unterschiedliche Flächen oder unterschiedliche Windungsdurchmesser auf.

Gemäß einer Ausführungsform sind die ersten Windungen schneckenförmig oder mäanderförmig oder spiralförmig in der ersten Ebene planar ausgebildet, beispielsweise gewickelt, und die zweiten Windungen sind schneckenförmig oder mäanderförmig oder spiralförmig in der zweiten Ebene planar ausgebildet, beispielsweise gewickelt. Mit zunehmender Windungszahl oder Ganghöhe nimmt somit auch die räumliche Ausdehnung, insbesondere die durch einen magnetischen Fluss durchdringbare Fläche, der jeweiligen Messspule zu. Dadurch kann in besonders vorteilhafter Weise ein induktionswirksamer Gesamtquerschnitt der jeweiligen Messspule erzeugt werden.

Gemäß einer Ausführungsform sind die ersten Windungen und die zweiten Windungen gegensinnig ausgebildet, beispielsweise gewickelt. Dadurch wird die Wirkungsweise einer Rogowski-Spule nachgebildet.

Gemäß einer Ausführungsform sind die erste Messspule und die zweite Messspule beidseitig eines einen Strom führenden Leiters anordenbar. Der Strom führende Leiter wird somit nicht durch die Messinduktivität umschlossen, sondern verläuft beispielsweise in derselben Ebene wie die beidseits angeordneten Messspulen.

Gemäß einer Ausführungsform sind die erste Ebene und die zweite Ebene parallel zueinander angeordnet, d.h. sie schneiden sich nicht bzw. liegen in derselben Ebene, oder sie verlaufen unter einem vorbestimmten Winkel, beispielsweise 10°, 30°, 45° oder 90° zueinander.

Gemäß einer Ausführungsform umfasst die Stromsensoranordnung ein Anschlussterminal mit einem ersten Messanschluss, welcher mit der ersten Messspule verbunden ist, und mit einem zweiten Messanschluss, welcher mit der zweiten Messspule über einen zweiten windungsfreien Verbindungsabschnitt elektrisch verbunden ist. Der zweite windungsfreie Verbindungsabschnitt überbrückt somit den Abstand zwischen den Messspulen.

Gemäß einer Ausführungsform ist der Strom führende Leiter oberhalb oder unterhalb des jeweiligen wicklungsfreien Verbindungsabschnitts anordenbar. Die Länge des jeweiligen wicklungsfreien Verbindungsabschnitts entspricht somit zumindest der Breite des Strom führenden Leiters.

Gemäß einer Ausführungsform ist die Messinduktivität auf oder in einer Leiterplatte angeordnet, wobei die ersten Windungen, die zweiten Windungen und der jeweilige windungsfreie Verbindungsabschnitt durch Streifenleitungen, insbesondere durch gedruckte Streifenleitungen, gebildet sind. Dadurch wird in vorteilhafter Weise eine Leiterplatten-Messanordnung bereitgestellt.

Gemäß einer Ausführungsform sind die erste Messspule und die zweite Messspule beidseitig des ersten Strom führenden Leiters des Mehrphasen-Leitersystems angeordnet sind, wobei die dritte Messspule und die vierte Messspule beidseitig des zweiten Strom führenden Leiters des Mehrphasen-Leitersystems angeordnet sind, und wobei die fünfte Messspule und die sechste Messspule beidseitig des dritten Strom führenden Leiters des Mehrphasen-Leitersystems angeordnet sind.

Die Messspulen der zweiten Messinduktivität und der dritten Messinduktivität können die Merkmale der korrespondierenden Messspulen der ersten Messinduktivität aufweisen. Die Messinduktivitäten können planar oder räumlich ausgedehnt in oder auf einer gemeinsamen Leiterplatte gebildet sein.

Gemäß einer Ausführungsform sind die erste Messspule und die zweite Messspule beidseitig eines ersten Strom führenden Leiters des Mehrphasen-Leitersystems angeordnet, wobei die dritte Messspule und die vierte Messspule beidseitig eines zweiten Strom führenden Leiters des Mehrphasen-Leitersystems angeordnet sind, und wobei die fünfte Messspule und die sechste Messspule beidseitig eines dritten Strom führenden Leiters des Mehrphasen-Leitersystems angeordnet sind. Auf diese Weise wird eine Messanordnung zur Erfassung von Strömen in einem Mehrphasen-Leiterplattensystem realisiert.

Gemäß einer Ausführungsform ist die Messinduktivität benachbart zu der der zweiten Messinduktivität angeordnet und wobei die zweite Messinduktivität benachbart zu der dritten Messinduktivität angeordnet ist, wobei die zweite Messspule und die dritte Messspule in unterschiedlichen Abständen zu dem ersten Strom führenden Leiter und zu dem zweiten Strom führenden Leiter anordenbar sind, und wobei die vierte Messspule und die fünfte Messspule seitlich benachbart in unterschiedlichen Abständen zu dem zweiten Strom führenden Leiter und zu dem dritten Strom führenden Leiter anordenbar sind.

Gemäß einer Ausführungsform sind die zweite Messspule und die dritte Messspule nebeneinander in unterschiedlichen Abständen zu dem ersten Strom führenden Leiter oder zu dem zweiten Strom führenden Leiter angeordnet, wobei die vierte Messspule und die fünfte Messspule nebeneinander in unterschiedlichen Abständen zu dem zweiten Strom führenden Leiter oder zu dem dritten Strom führenden Leiter angeordnet sind. Die Messinduktivitäten sind somit benachbart zueinander und in einer Reihe ausgerichtet. Zwischen den jeweiligen Messspulen der Messinduktivitäten verlaufen die Strom führenden Leiter. Aufgrund der vergrößerten Abstände zwischen den Messinduktivitäten sind die Störeinflüsse von Strömen in benachbarten Strom führenden Leitern reduziert.

Gemäß einer Ausführungsform ist die zweite Messinduktivität bezüglich der Messinduktivität und bezüglich der dritten Messinduktivität lateral, insbesondere in Verlaufsrichtung des zweiten Strom führenden Leiters, versetzt. Die Messinduktivitäten sind somit lateral hintereinander angeordnet. Dadurch wird eine besonders Raum sparende Anordnung der Messinduktivitäten ermöglicht.

Gemäß einer Ausführungsform sind die dritte Messspule unmittelbar neben dem ersten Strom führenden Leiter und die vierte Messspule unmittelbar neben dem dritten Strom führenden Leiter angeordnet. Auf diese Weise können die Messspulen auch bei enger benachbarten Strom führenden Leitern, beispielsweise auf einer Leiterplatte, angeordnet werden.

Gemäß einer Ausführungsform verlaufen die Strom führenden Leiter des Mehrphasen-Leitersystems durch die Ecken eines geometrischen Dreiecks. Die zweite Messinduktivität und die dritte Messinduktivität sind an den Ecken des gedachten geometrischen Dreiecks angeordnet. Dadurch sind die Messinduktivitäten symmetrisch bezüglich einander angeordnet, sodass eine effiziente Unterdrückung von Störeinflüssen, welche jeweils von anderen Strom führenden Leitern stammen können, bewirkt werden kann. Zusätzlich können die geometrische Ausdehnung und/oder Windungszahlen der zweiten, vierten und sechsten Messspule, welche innerhalb des gedachten Dreiecks angeordnet sind, reduziert werden.

Gemäß einer Ausführungsform weist die zweite Messspule einen geringeren Windungsdurchmesser oder weniger Windungen als die erste Messspule auf, die vierte Messspule weist einen geringeren Windungsdurchmesser oder weniger Windungen als die dritte Messspule auf und die sechste Messspule weist einen geringeren Windungsdurchmesser oder weniger Windungen als die fünfte Messspule auf. Dadurch können Wirkungen von magnetischen Streufeldern effizient reduziert werden.

Gemäß einer Ausführungsform ist die jeweilige Messinduktivität ausgebildet, ein Ausgangssignal, insbesondere eine Ausgangsspannung oder einen Ausgangsstrom, auszugeben, welches jeweils von einer Stromstärke in dem jeweiligen Strom führenden Leiter abhängig ist, wobei die Stromsensoranordnung ferner eine Überwachungseinrichtung umfasst, welche ausgebildet ist, eine Überschreitung eines Stromschwellwertes durch einen elektrischen Strom in dem jeweiligen Strom führenden Leiter auf der Basis des Ausgangssignals der jeweiligen Messinduktivität zu überwachen.

Gemäß einer Ausführungsform umfasst die Überwachungseinrichtung folgende Merkmale: einen ersten Überwachungspfad zum Empfangen des Ausgangssignals der Messinduktivität mit einem ersten Schwellwertdetektor und einer dem ersten Schwellwertdetektor nachgeschalteten ersten Diode; einen zweiten Überwachungspfad zum Empfangen des Ausgangssignals der zweiten Messinduktivität mit einem zweiten Schwellwertdetektor und einer dem zweiten Schwellwertdetektor nachgeschalteten zweiten Diode; einen dritten Überwachungspfad zum Empfangen des Ausgangssignals der dritten Messinduktivität mit einem dritten Schwellwertdetektor und einer dem dritten Schwellwertdetektor nachgeschalteten dritten Diode; und einem Steueranschluss, mit welchem die Kathode der ersten Diode, die Kathode der zweiten Diode und die Kathode der dritten Diode elektrisch verbunden sind; wobei der jeweilige Schwellwertdetektor ausgebildet ist, bei Überschreitung eines Schwellwertes durch einen durch das jeweilige Ausgangssignal repräsentierten Strom einen Ausgangsstrom zu erzeugen.

Gemäß einer Ausführungsform umfasst die Stromsensoranordnung eine Kurzschlusserzeugungseinrichtung, welche dem Steueranschluss nachgeschaltet und ausgebildet ist, ansprechend auf einen Ausgangsstrom am Steueranschluss zumindest einen der Strom führenden Leiter, insbesondere für ein vorbestimmtes Kurzschlussintervall, kurzzuschließen.

Weitere Ausführungsformen werden Bezug nehmend auf die beiliegenden Zeichnungen erläutert. Es zeigen:
- Fig. 1A, 1B, 1C:: Stromsensoranordnungen;
- Fig. 2A, 2B: Stromsensoranordnungen;
- Fig. 3: eine Stromsensoranordnung;
- Fig. 4: eine Stromsensoranordnung;
- Fig. 5: eine Stromsensoranordnung;
- Fig. 6: eine Stromsensoranordnung; und
- Fig. 7: eine Stromsensoranordnung.

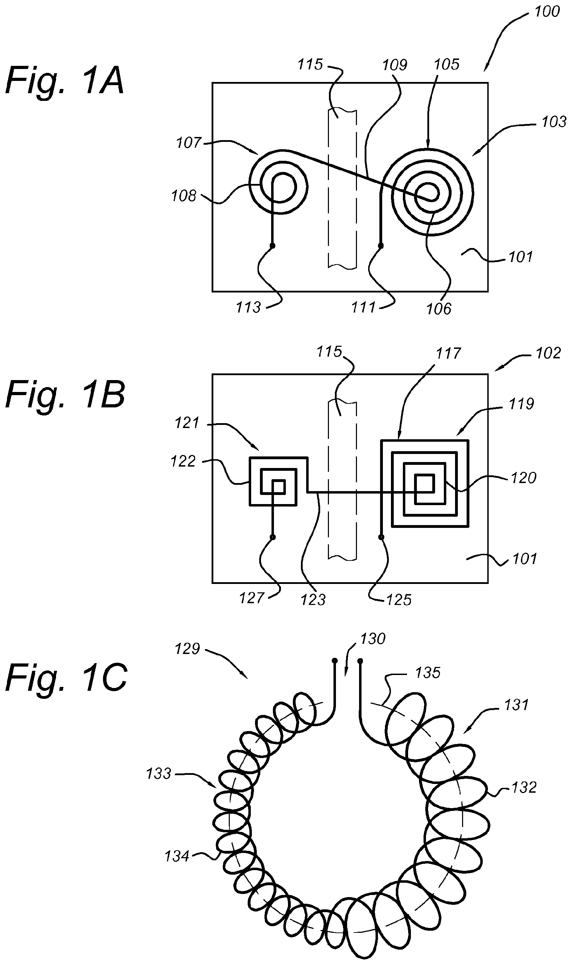

Fig. 1A zeigt eine Stromsensoranordnung 100 mit einer Messinduktivität 103, wobei die Messinduktivität 103 eine erste Messspule 105 mit ersten Windungen 106 umfasst, welche in einer ersten Ebene angeordnet sind, eine zweite Messspule 107 mit zweiten Windungen 108, welche in einer zweiten Ebene angeordnet sind; und einen windungsfreien Verbindungsabschnitt 109, welcher die erste Messspule 105 mit der zweiten Messspule 107 elektrisch in Reihe verbindet. Die erste Ebene und die zweite Ebene sind beispielsweise parallel, d.h. die Messspulen 105, 107 sind in derselben Ebene angeordnet.

Die erste Messspule 105 kann beispielsweise mehr Windungen und/oder einen größeren Windungsdurchmesser bzw. von einem Magnetfluss durchdringbare Fläche aufweisen als die zweite Messspule 107.

Die Messinduktivität 103 kann auf einer Leiterplatte 101 planar oder in der Leiterplatte 101 räumlich angeordnet sein.

Der windungsfreie Verbindungsabschnitt 109 ist beispielsweise ein gerades oder gebogenes Leiterstück, das jedoch keine Windungen umfasst.
In dem in Fig. 1A dargestellten Beispiel sind die Windungen 106, 108 der Messspulen 105, 107 schneckenförmig und im gegenläufigen Sinn ausgebildet, beispielsweise gewickelt. Die Windungen 106, 108 können gleiche oder unterschiedliche Durchmesser und/oder gleiche oder unterschiedliche Windungszahlen aufweisen.

Ein Strom führender Leiter 115 kann zwischen den Messspulen 105, 107 angeordnet werden, sodass die Messspulen 105, 107 beidseitig des Strom führenden Leiters 115 angeordnet sind. Der Strom führender Leiter 115 kreuzt ferner den windungsfreien Verbindungsabschnitt 109, welcher die Messspulen 105, 107 verbindet.

Fig. 1B zeigt eine Stromsensoranordnung 102 mit einer Messinduktivität 117, wobei die Messinduktivität 117 eine erste Messspule 119 mit ersten Windungen 120, welche in einer ersten Ebene angeordnet sind, eine zweite Messspule 121 mit zweiten Windungen 122, welche in einer zweiten Ebene angeordnet sind, und einen windungsfreien Verbindungsabschnitt 123 umfasst, welcher die erste Messspule 119 mit der zweiten Messspule 121 elektrisch in Reihe verbindet. Die erste Ebene und die zweite Ebene sind beispielsweise parallel, d.h. die Messspulen 119, 121 sind in derselben Ebene angeordnet. Der windungsfreie Verbindungsabschnitt 123 ist beispielsweise ein gerades oder gebogenes Leiterstück, das jedoch keine Windungen umfasst.

In dem in Fig. 1B dargestellten Beispiel sind die Windungen 120, 122 der Messspulen 119, 121 spiralförmig und im gegenläufigen Sinn ausgebildet. Die Windungen 120, 122 können gleiche oder unterschiedliche Durchmesser und/oder gleiche oder unterschiedliche Windungszahlen aufweisen.

Ein Strom führender Leiter 115 kann zwischen den Messspulen 105, 107 angeordnet werden, sodass die Messspulen 105, 107 beidseitig des Strom führenden Leiters 115 angeordnet sind. Der Strom führende Leiter 115 kreuzt ferner den windungsfreien Verbindungsabschnitt 109, welcher die Messspulen 105, 107 verbindet.

Die erste Messspule 119 kann beispielsweise mehr Windungen und/oder einen größeren Windungsdurchmesser bzw. von einem Magnetfluss durchdringbare Fläche aufweisen als die zweite Messspule 121.

Die Messinduktivität 117 kann auf einer Leiterplatte 101 planar oder in der Leiterplatte 101 räumlich angeordnet sein.

Gemäß einer Ausführungsform können die in den Figuren 1A und AB dargestellten Messspulen sich jedoch räumlich, beispielsweise zylindrisch, erstrecken.

Fig. 1C zeigt eine Stromsensoranordnung 129 mit einer Messinduktivität 130, wobei die Messinduktivität 130 eine erste Messspule 131 mit ersten Windungen 132 und eine zweite Messspule 133 mit zweiten Windungen 134 umfasst. Die erste Messspule 131 und die zweite Messspule 133 bilden gemeinsam eine Torroidform mit einem Kern 135. Der Kern 135 kann beispielsweise ein Luftkern oder ein weichmagnetischer Kern sein. Die erste Messspule 131 kann beispielsweise mehr Windungen und/oder einen größeren Windungsdurchmesser bzw. von einem Magnetfluss durchdringbare Fläche aufweisen als die zweite Messspule 133. Die erste Messspule 131 und die zweite Messspule 133 sind in Reihe geschaltet und bilden gemäß einer Ausführungsform daher eine modifizierte Rogowski-Spule.

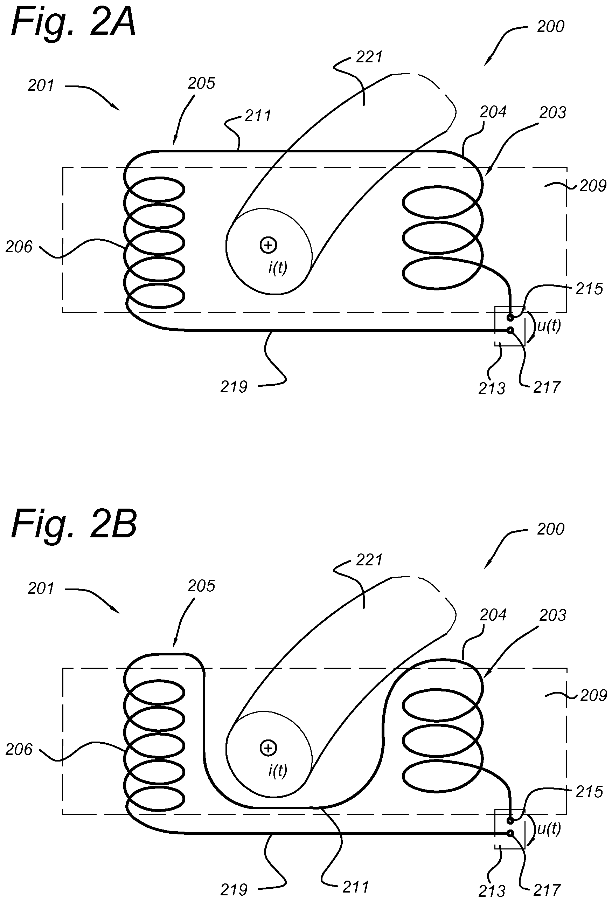

Fig. 2A und 2B zeigen eine Stromsensoranordnung 200 mit einer Messinduktivität 201. Die Messinduktivität 201 umfasst eine erste Messspule 203 mit Windungen 204 und eine zweite Messspule 205 mit Windungen 206, welche als Leiterbahnen, beispielsweise Streifenleitungen, einer Leiterplatte 209 gebildet sind. Die Radien der Windungen 204, 206 und/oder die Windungszahlen der Windungen 204, 206 können gleich oder unterschiedlich sein.

Weiterhin umfasst die Stromsensoranordnung 200 ein Anschlussterminal 213 mit einem ersten Messanschluss 215, welcher mit der ersten Messspule 203 verbunden ist, und mit einem zweiten Messanschluss 217, welcher mit der zweiten Messspule 205 über einen zweiten windungsfreien Verbindungsabschnitt 219 elektrisch verbunden ist.

Die windungsfreien Verbindungsabschnitte 217 und 211 überbrücken eine Lücke zwischen den Messspulen 201, 203, in welcher ein Strom führender Leiter 221 angeordnet werden kann.

Der windungsfreie Verbindungsabschnitt 211 kann wie in Fig. 2A dargestellt oberhalb oder, wie in Fig. 2B dargestellt, unterhalb des Strom führenden Leiters 221 angeordnet sein. Der zweite windungsfreie Verbindungsabschnitt 219 kann ebenfalls oberhalb oder unterhalb des Strom führenden Leiters 221 angeordnet sein. Die windungsfreien Verbindungsabschnitte 211, 219 tragen aufgrund der Windungsfreiheit weitaus weniger zu einer magnetischen Kopplung bei als die Windungen 204, 206. Der Einfluss der windungsfreien Verbindungsabschnitte 211, 219 kann bei der Stromerfassung daher vernachlässigt werden, insbesondere wenn diese senkrecht oder nahezu senkrecht zu dem Strom führenden Leiter angeordnet sind.

Die in den Fig. 1A, 1B, 1C, 2A und 2B dargestellten Messinduktivitäten liefern eine Messspannung u(t), welche gemäß dem Induktionsgesetz einer zeitlichen Ableitung eines Messstroms i(t) in dem Strom führenden Leiter 221 entspricht. Die Messinduktivitäten 109, 117, 201 können daher als modifizierte Rogowski-Spulen aufgefasst werden.

Die in den Fig. 2A und 2B dargestellte Messinduktivität 201 kann gemäß einer Ausführungsform planare Messspulen 203, 205 umfassen, welche auf der Leiterplatte 209 angeordnet sind.

Gemäß einer Ausführungsform sind die erste Messspule 203 und die zweite Messspule 205 räumlich bzw. ausgedehnt in der Leiterplatte 209 angeordnet. Hierzu können die Windungen 204, 206 zwei Seiten des Leiters 221, beispielsweise Primärleiters, komprimiert und als Leiterbahnen einer Leiterplatte ausgeführt werden. Dadurch ergeben sich beispielswiese spiralförmige Windungen 204, 206 auf unterschiedlichen Lagen der Leiterplatte 209, welche eine Leiterkarte sein kann, und von oben eine 8-förmige Grundstruktur.

Gemäß einer Ausführungsform kann der jeweiligen Messinduktivität ein Integrator nachgeschaltet werden, um ein Ausgangssignal zu erzeugen, das dem Messstrom proportional ist. Der Integrator kann durch eine an sich bekannte Schaltung mit einem rückgekoppelten Operationsverstärker mit einem parallelen R-C-Glied in dem Rückkopplungszweig und einem Vorschaltwiderstand realisiert werden.

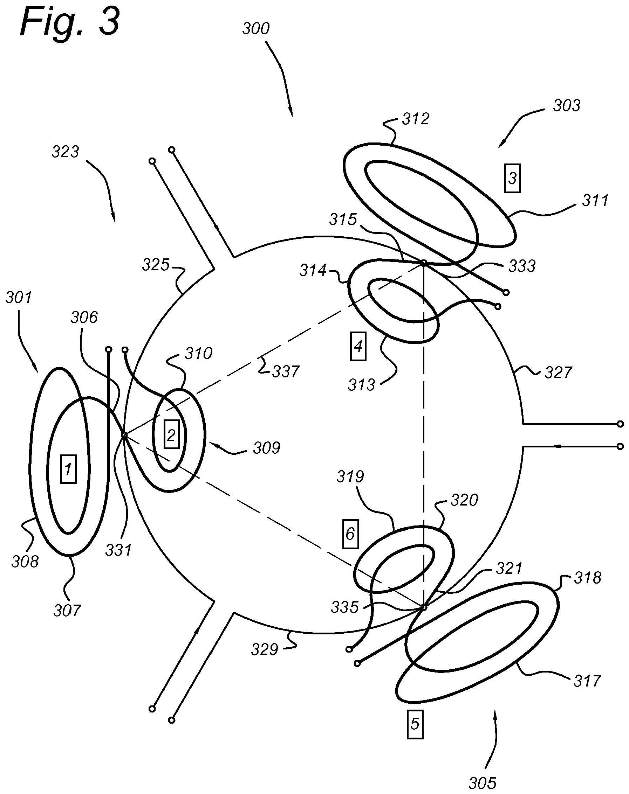

Fig. 3 zeigt eine Stromsensoranordnung 300 mit einer Messinduktivität 301, einer zweiten Messinduktivität 303 und mit einer dritten Messinduktivität 305.

Die Messinduktivität 301 umfasst eine erste Messspule 307 mit ersten Windungen 308 und eine zweite Messspule 309 mit zweiten Windungen 310. Ein windungsfreier Verbindungsabschnitt 306 verbindet die Messspulen 307 und 309 in Reihe.

Die zweite Messinduktivität 303 umfasst eine dritte Messspule 311 mit ersten Windungen 312, eine vierte Messspule 313 mit zweiten Windungen 314, und einen windungsfreien Verbindungsabschnitt 315, welcher die Messspulen 311 und 313 in Reihe verbindet.

Die dritte Messinduktivität 305 umfasst eine fünfte Messspule 317 mit ersten Windungen 318, eine sechste Messspule 319 mit zweiten Windungen 320, und einen windungsfreien Verbindungsabschnitt 321, welcher die fünfte Messspule 317 mit der sechsten Messspule 319 elektrisch verbindet.

Die Stromsensoranordnung 300 ist vorgesehen, elektrische Ströme in den Strom führenden Leitern 325, 327 und 329 eines Mehrphasen-Leitersystems 323 zu erfassen. Die Strom führenden Leiter 325, 327 und 329 verlaufen beispielsweise kreisbogenförmig durch die Ecken 331, 333, 335 eines gedachten, geometrischen Dreiecks 337.

Die Messinduktivität 301 ist an der Ecke 331 angeordnet und für die Stromerfassung in dem ersten Strom führenden Leiter 325 vorgesehen. Die zweite Messinduktivität 303 ist an der Ecke 333 angeordnet und für die Stromerfassung in dem ersten Strom führenden Leiter 327 vorgesehen. Die dritte Messinduktivität 305 ist an der Ecke 335 angeordnet und für die Stromerfassung in dem ersten Strom führenden Leiter 329 vorgesehen.

Wie in Fig. 3 dargestellt, hat die zweite Messspule 309 einen geringeren Windungsdurchmesser oder weniger Windungen als die erste Messspule 307, die vierte Messspule 313 hat einen geringeren Windungsdurchmesser oder weniger Windungen als die dritte Messspule 311 und die sechste Messspule 319 hat einen geringeren Windungsdurchmesser oder weniger Windungen als die fünfte Messspule 317.

Durch die geometrische Anordnung der Messinduktivitäten 301, 303 und 305 an den Ecken 331, 333, 335 sowie durch die unterschiedlichen Durchmesser bzw. Windungszahlen der Messspulen kann erreicht werden.

Durch die in Fig. 3 dargestellte Geometrieoptimierung kann erreicht werden, dass die magnetische Kopplung des Stromes I1 durch den Leiter 325 in der dritten Messspule 311 und in der vierten Messspule 313, in der fünften Messspule 315 sowie in der sechsten Messspule 319 reduziert oder nahezu Null wird. Dazu kann beispielweise die Fläche der dritten Messspule 311 größer als die Fläche der vierten Messspule 313 gewählt werden, die wiederum räumlich näher an den Leiter 325 positioniert ist. Dadurch können in der dritten Messspule 311 und in der vierten Messspule 313 zwei gleich große, mit unterschiedlichem Vorzeichen behaftete induzierte Spannungsanteile des Stromes erreicht werden, so dass in Summe der Leiter 325 nicht auf die dritte Messspule 311 und die vierte Messspule 313 wirkt. Durch die Symmetrie der Anordnung gilt dies für alle drei Komponenten und jeder Strom führende Leiter 325, 327, 329 (Primärleiter) 10, 11, 12 wirkt nur auf seine zugehörige erste und zweite Messspule 308, 31 0, dritte und vierte Messspule 311 und 313, und fünfte bis sechse Messspule 317, 320.

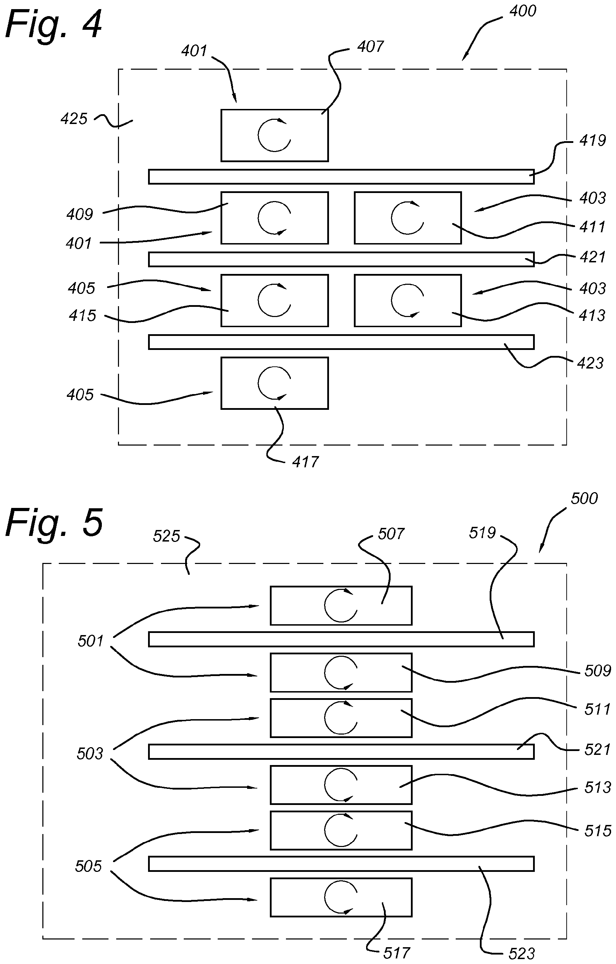

Fig. 4 zeigt eine Stromsensoranordnung 400 mit einer Messinduktivität 401, einer zweiten Messinduktivität 403 und mit einer dritten Messinduktivität 405.

Die Messinduktivität 401 umfasst eine erste Messspule 407 mit ersten Windungen und eine zweite Messspule 409 mit zweiten Windungen. Die Messspulen 407, 409 sind in Reihe verbunden.

Die zweite Messinduktivität 403 umfasst eine dritte Messspule 411 mit ersten Windungen und eine vierte Messspule 413 mit zweiten Windungen. Die Messspulen 411, 413 sind in Reihe verbunden.

Die dritte Messinduktivität 405 umfasst eine dritte Messspule 415 mit ersten Windungen und eine vierte Messspule 417 mit zweiten Windungen. Die Messspulen 415, 417 sind in Reihe verbunden.

Die in Fig. 4 dargestellten Messspulen 407, 409, 411, 413, 415, 417 können beispielsweise schneckenförmige oder spiralförmige, planare Messspulen mit den vorstehend oder nachstehend beschriebenen Merkmalen sein.

Gemäß einer Ausführungsform sind die Messspulen 407, 409, 411, 413, 415, 417 räumlich bzw. ausgedehnt in der Leiterplatte 425 angeordnet. Hierzu können die Windungen zwei Seiten des jeweiligen Leiters 419, 421, 423, beispielsweise Primärleiters, komprimiert und als Leiterbahnen der Leiterplatte 425 ausgeführt werden. Dadurch ergeben sich beispielswiese spiralförmige Windungen auf unterschiedlichen Lagen der Leiterplatte 209, welche eine Leiterkarte sein kann, und von oben eine 8-förmige Grundstruktur.

Die Stromsensoranordnung 400 ist vorgesehen, elektrische Ströme in den Strom führenden Leitern 419, 421 und 423 eines Mehrphasen-Leitersystems zu erfassen. Die Strom führenden Leiter 419, 421 und 423 sind beispielsweise parallel angeordnet.

Zur Erfassung der in den Strom führenden Leitern 419, 421 und 423 fließenden Ströme sind die Messspulen 407, 409, 411, 413, 415, 417 der Messinduktivitäten 401, 403 und 405 jeweils seitlich der Strom führenden Leiter 419, 421 und 423 angeordnet. Die Messinduktivitäten 401, 403 und 405 sind jedoch zumindest teilweise lateral entlang der Verlaufsrichtung der Strom führenden Leiter verschoben. Hierzu ist beispielsweise die zweite Messinduktivität 403 bezüglich der Messinduktivität 401 und bezüglich der dritten Messinduktivität lateral versetzt. Dadurch kann die Messung auch bei dicht nebeneinander liegenden Strom führenden Leitern 419, 421 und 423 durchgeführt werden. Außerdem können dadurch die Störeinflüsse reduziert werden.

Die Stromsensoranordnung 400 kann, beispielsweise gemeinsam mit den Strom führenden Leitern 419, 421 und 423, auf einer Leiterplatte 425 angeordnet sein.

Die in Fig. 4 dargestellten Messspulen 407, 409, 411, 413, 415, 417 sind gegensinnig in die beispielsweise in Fig. 4 durch Pfeile angedeuteten Richtungen ausgebildet. Dadurch können von benachbarten Strom führenden Leitern 419, 421 und 423 stammende Störeinflüsse reduziert werden.

Gemäß einer Ausführungsform sind die Strom führenden Leiter 419, 421, 423 Primärleiter und können einzeln oder gleichzeitig und mit beliebigem Vorzeichen behaftete Kurzschlussströme führen. Die Messspulen 407, 409 bzw. 411, 413 bzw. 415, 417 messen die Ströme (Messströme) in den Leitern 419, 421, 423 durch Induktion.

Die Messspulen 407, 409 sind gegensinnig in Reihe geschaltet und die induzierten Spannungen des stromdurchflossenen Primärleiters 419 überlagern sich konstruktiv, da das Vorzeichen des magnetischen Feldes des Leiters 419 in den Messspulen 407, 409 gegensinnig ist. Gleichzeitig koppelt das Feld des Primärleiters 419 in die Messspulen 411, 413. Durch die gegensinnige Reihenschaltung der Messspulen 411, 413 subtrahieren sich jedoch die induzierten Spannungen, da das Vorzeichen des magnetischen Feldes in der zweiten Messinduktivität 401 mit den Messspulen 411, 413 gleich ist und es verbleibt im Idealfall kein Spannungssignal an der zweiten Messinduktivität 401 mit den Messspulen 411, 413.

Dieselben Ausführungen gelten auch für die Primärleiter 421 und 423, so dass der Primärleiter 419 im Wesentlichen nur auf die Messspulen 407, 409 wirkt, der Primärleiter 421 im Wesentlichen nur auf die Messspulen 411, 413 und der Primärleiter 423 im Wesentlichen nur auf die Messspulen 415, 416 der dritten Messinduktivität 405. Somit können mit drei Messspannungen die unterschiedlichen Ströme gemessen und detektiert werden.

Fig. 5 zeigt eine Stromsensoranordnung 500 mit einer Messinduktivität 501, einer zweiten Messinduktivität 503 und mit einer dritten Messinduktivität 505.

Die Messinduktivität 501 umfasst eine erste Messspule 507 mit ersten Windungen und eine zweite Messspule 509 mit zweiten Windungen. Die Messspulen 507, 509 sind in Reihe verbunden.

Die zweite Messinduktivität 503 umfasst eine dritte Messspule 511 mit ersten Windungen und eine vierte Messspule 513 mit zweiten Windungen. Die Messspulen 511, 513 sind in Reihe verbunden.

Die dritte Messinduktivität 505 umfasst eine dritte Messspule 515 mit ersten Windungen und eine vierte Messspule 517 mit zweiten Windungen. Die Messspulen 515, 517 sind in Reihe verbunden.

Die in Fig. 5 dargestellten Messspulen 507, 509, 511, 513, 515, 517 können beispielsweise schneckenförmige oder spiralförmige Messspulen mit den vorstehend oder nachstehend beschriebenen Merkmalen sein.

Gemäß einer Ausführungsform sind die Messspulen 507, 509, 511, 513, 515, 517 räumlich bzw. ausgedehnt in der Leiterplatte 525 angeordnet. Hierzu können die Windungen zwei Seiten des jeweiligen Leiters 519, 521, 523, beispielsweise Primärleiters, komprimiert und als Leiterbahnen der Leiterplatte 525 ausgeführt werden. Dadurch ergeben sich beispielswiese spiralförmige Windungen auf unterschiedlichen Lagen der Leiterplatte 525, welche eine Leiterkarte sein kann, und von oben eine 8-förmige Grundstruktur.

Die Stromsensoranordnung 500 ist vorgesehen, elektrische Ströme in den Strom führenden Leitern 519, 521 und 523 eines Mehrphasen-Leitersystems zu erfassen. Die Strom führenden Leiter 519, 521 und 523 sind beispielsweise parallel angeordnet.

Die Messinduktivitäten 501, 503, 505 mit den Messspulen 507, 509, 511, 513, 515, 517 sind im Unterschied zu dem in Fig. 4 dargestellten Ausführungsbeispiel in einer Reihe angeordnet. So sind die zweite Messspule 509 und die dritte Messspule 511 beispielsweise unmittelbar nebeneinander in unterschiedlichen Abständen zu dem ersten Strom führenden Leiter 519 oder zu dem zweiten Strom führenden Leiter 521 angeordnet. Die vierte Messspule 513 und die fünfte Messspule 515 sind analog nebeneinander in unterschiedlichen Abständen zu dem zweiten Strom führenden Leiter 521 oder zu dem dritten Strom führenden Leiter 523 angeordnet.

Die in Fig. 5 dargestellten Messspulen 507, 509, 511, 513, 515, 517 sind gegensinnig in die beispielsweise in Fig. 4 durch Pfeile angedeuteten Richtungen ausgebildet. Dadurch können von benachbarten Strom führenden Leitern 519, 521 und 523 stammende Störeinflüsse reduziert werden.

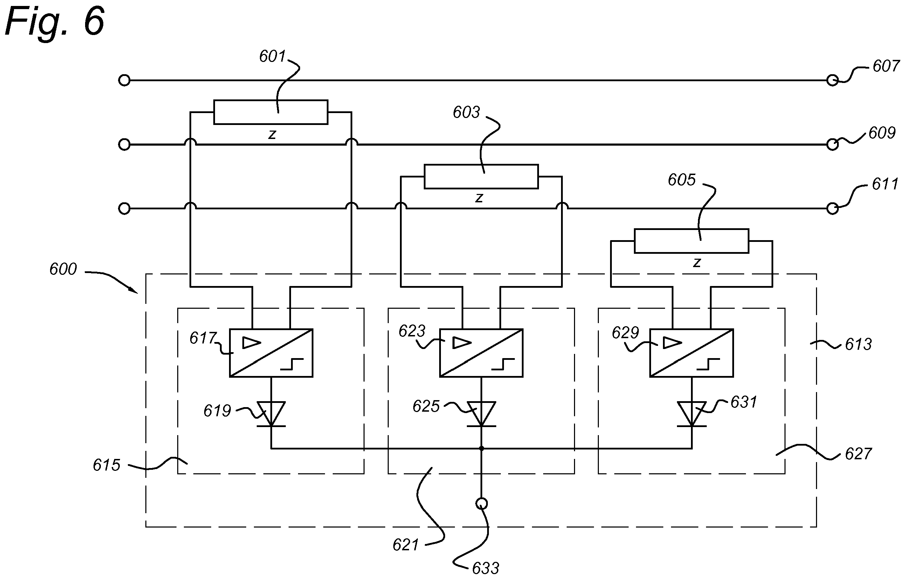

Fig. 6 zeigt eine Stromsensoranordnung 600 mit einer Messinduktivität 601, einer zweiten Messinduktivität 603 und einer dritten Messinduktivität 605. Die Messinduktivitäten 601, 603 und 605 weisen jeweils Messspulen auf, welche beidseitig des jeweiligen Strom führenden Leiters 607, 609 und 611 eines Mehrphasen-Leitersystems angeordnet sind. Die Messinduktivitäten 601, 603, 605 weisen jeweils beispielsweise eine Impedanz Z auf.

Den Messinduktivitäten 601, 603, 605 ist eine Überwachungseinrichtung 613 nachgeschaltet, welche ausgebildet ist, eine Überschreitung eines Stromschwellwertes durch einen Strom in dem jeweiligen Strom führenden Leiter 607, 609 und 611 auf der Basis des Ausgangssignals, beispielsweise eines Stroms oder einer Spannung, der jeweiligen Messinduktivität 601, 603 und 605 zu überwachen.

Hierzu umfasst die Überwachungseinrichtung einen ersten Überwachungspfad 615 zum Empfangen des Ausgangssignals der Messinduktivität 601 mit einem ersten Schwellwertdetektor 617 und einer dem ersten Schwellwertdetektor 617 nachgeschalteten ersten Diode 619, einen zweiten Überwachungspfad 621 zum Empfangen des Ausgangssignals der zweiten Messinduktivität 603 mit einem zweiten Schwellwertdetektor 623 und einer dem zweiten Schwellwertdetektor 623 nachgeschalteten zweiten Diode 625, sowie einen dritten Überwachungspfad 627 zum Empfangen des Ausgangssignals der dritten Messinduktivität 605 mit einem dritten Schwellwertdetektor 629 und einer dem dritten Schwellwertdetektor 629 nachgeschalteten dritten Diode 631. Die jeweilige Diode steht allgemein stellvertretend für einen Gleichrichter oder für eine Gleichrichterschaltung.

Die Messinduktivitäten 601, 603, 605 sind vorgesehen, Messströme in den Strom führenden Leitern 607, 609 und 611 zu erfassen. Die Schwellwertdetektoren 617, 623 und 629 können vorgeschaltete Integratoren aufweisen, um die Ausgangsignale der Messinduktivitäten 601, 603, 605 durch Integration in Ausgangssignale zu überführen, welche proportional zu den Messströmen sind.

Die Schwellwertdetektoren 617, 623, 629 sind jeweils ausgebildet, bei Überschreitung eines Schwellwertes durch einen durch das jeweilige Ausgangssignal repräsentierten Strom einen Ausgangsstrom zu erzeugen.

Die Dioden 619, 625 und 631 sind kathodenseitig mit einem Steueranschluss 633 verbunden, wodurch eine "Oder"-Verknüpfung der Ausgangsströme der Schwellwertdetektoren 617, 623, 629 realisiert wird. Durch die "Oder"-Verknüpfung wird erreicht, dass der maximale Ausgangsstrom am Steueranschluss ausgegeben wird.

Die Schwellwertdetektoren 617, 623 und 629 vergleichen beispielsweise die Ausgangssignale der Messinduktivitäten 601, 603, 605 mit vorbestimmten Schwellwerten, welche beispielsweise einem 10-fachen oder einem 20-fachen eines vorgegebenen Nennstroms entsprechen. Dadurch kann eine effektive Kurzschlusserkennung realisiert werden.

Alternativ zu den in Fig. 6 dargestellten Schwellwertdetektoren in jedem der drei Zweige 615, 621, 627 kann auch eine einzelne Schwellwertdetektion am Steueranschluss 633 633 angeordnet sein. Dies kann insbesondere vorteilhaft sein, wenn es irrelevant ist, an welchem Primärleiter 607, 609, 611 ein zu hoher Strom auftritt. In diesem Fall können die einzelnen Schwellwertdetektoren in 617, 623, 629 entfallen und die Stufen 617, 623, 629 beispielsweise nur Integrations- und Verstärkungsstufen aufweisen.

Die in Fig. 6 dargestellte Stromsensoranordnung 600 kann daher gemäß einer Ausführungsform für eine Kurzschlusserkennung eingesetzt werden.

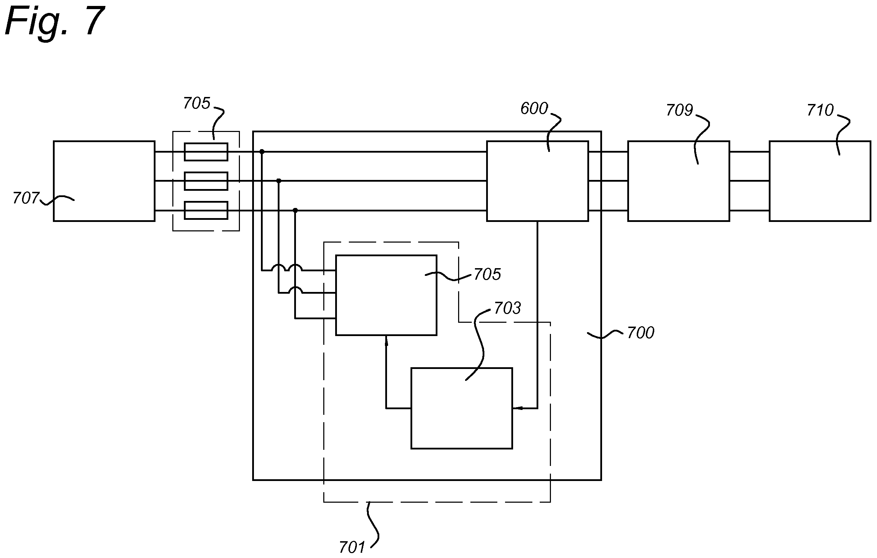

Fig. 7 zeigt eine hierzu erweiterte Stromsensoranordnung 700 mit beispielsweise der in Fig. 6 dargestellten Stromsensoranordnung 600. Der Stromsensoranordnung 600 ist eine Kurzschlusserzeugungseinrichtung 701 nachgeschaltet. Die Kurzschlusserzeugungseinrichtung 701 ist vorgesehen, ansprechend auf einen Ausgangsstrom am Steueranschluss 633 der Stromsensoranordnung 600, insbesondere ansprechend auf ein Vorliegen eines Ausgangsstroms an dem Steueranschluss 633, zumindest einen der Strom führenden Leiter 607, 609 und 611 oder einige der Strom führenden Leiter 607, 609 und 611 oder alle Strom führenden Leiter 607, 609 und 611 kurzzuschließen. Der Kurzschluss kann beispielsweise durch eine elektrische Verbindung zwischen zumindest zwei der Strom führenden Leiter 607, 609 und 611 (Phasenkurzschluss) oder durch eine elektrische Verbindung zwischen zumindest zwei der Strom führenden Leiter 607, 609 und 611 und einem Grundpotential realisiert werden.

Die Kurzschlusserzeugungseinrichtung 701 umfasst hierzu beispielsweise eine Zündimpulseinrichtung 703 zum Erzeugen eines Zündimpulses für den Kurzschluss, und eine der Zündimpulseinrichtung 703 nachgeschaltete Kurzschlusseinrichtung 705 zum Erzeugen des Kurzschlusses ansprechend auf den Zündimpuls. Die Kurzschlusseinrichtung 705 ist mit den Strom führenden Leitern 607, 609 und 611 verbunden.

Die Zündimpulseinrichtung 703 kann eine externe Energiequelle umfassen oder durch den Kurzschlussstrom gespeist sein.

Auf diese Weise kann effizient ein zündbarer Hilfskurzschluss erzeugen werden, um die Strom führenden Leiter 607, 609 und 611 bei einer Stromüberhöhung zu entlasten.

Gemäß einer Ausführungsform bilden Merkmale der erweiterten Stromsensoranordnung 700 ein eigenständiges Kurzschlusserzeugungssystem.

Hierbei kann der erweiterten Stromsensoranordnung 700 eine Kurzschlussschutzeinrichtung 705 vorgeschaltet sein, welche in an sich bekannter Weise Sicherungen oder Lastschutzschalter umfassen kann. Eingangsseitig kann ferner eine Versorgungsspannung 707 vorgesehen sein, welche beispielsweise eine dreiphasige Versorgungsspannung mit 400 V und 50 Hz, mit oder ohne einen Neutralleiter, liefert.

Der erweiterten Stromsensoranordnung 700 kann ferner ein Schaltgerät 709 nachgeschaltet sein, das beispielsweise als ein Frequenzumrichter, ein Schütz oder ein Halbleitermotorschaltgerät ausgeführt sein kann. Dem Schaltgerät 709 kann eine elektrische Last 711, beispielsweise ein Motor, Heizelemente oder Lampen, nachgeschaltet sein.

Bezüglich weiterer Details bezüglich der in den Fig. 6 und 7 dargestellten Ausführungsbeispiele wird auf den Inhalt der Druckschrift WO 2012/123541 verwiesen, welche dieser Beschreibung vollständig zuzurechnen ist.

Die Erkennung des Kurzschlusses kann gemäß einer Ausführungsform so ausgeführt werden, dass auch Erdschlüsse erkannt werden. Durch geeignete Dimensionierung der Erkennung ist es möglich, jeden beliebigen Stromwert als Schaltschwelle für die Erkennung des Kurzschlusses zu definieren. Damit können auch relativ kleine Kurzschlussströme, z. B. das 10 bis 20-fache des Nennstromes eines Antriebs oder eines Motors erkannt und der Hilfskurzschluss erzeugt werden. Somit können konventionelle Kurzschlusseinrichtungen, die typischerweise insb. bei kleinen Kurzschlussströmen als kritisch einzustufen sind, ihre volle Performance (wie bei einem Nennkurzschluss) entfalten.

Gemäß einer Ausführungsform können die Messanordnungen, beispielsweise die Stromsensoranordnungen, zur Messung von Kurzschlussströmen in einem Drehstromnetz eingesetzt werden.

Gemäß einer Ausführungsform kann eine Rogowski-Spule als Basis für eine Strommessung dienen. Diese kann komprimiert zu einer 8-förmigen Grundstruktur auf einer Leiterplatte realisiert werden. Dadurch kann die Präzision reduziert sein, jedoch eine kostengünstige Implementierung ermöglicht werden.

Gemäß einer Ausführungsform ist eine dreifache Ausführung der Messspule zur gleichzeitigen Messung von bis zu 3 Kurzschlussströmen möglich. Hierbei können verschiedene Anordnungen, beispielsweise eine versetzte Anordnung, eine nebeneinanderliegende Anordnung und/oder eine symmetrische Anordnung, möglich sein.

Gemäß einer Ausführungsform nimmt jede Messspule den ihr zugehörigen Kurzschlussstrom deutlich stärker wahr als die Ströme der benachbarten Leiter. Der Faktor kann dabei 2 bis mehrere Größenordnungen betragen. Dies kann durch die Rogowski-Struktur, beispielsweise durch die 8-Form sowie den eingeschlossenen Leiter, bedingt sein.

Gemäß einer Ausführungsform umfasst die Stromsensoranordnung drei Messsignale, welche integriert und gleichgerichtet werden können.

Gemäß einer Ausführungsform umfasst die Stromsensoranordnung eine elektronische Schaltung, welche die Messsignale vergleicht.

Gemäß einer Ausführungsform umfasst die Stromsensoranordnung eine elektronische Schaltung, welche durch das stärkste Messsignal zur Bewertung eines Kurzschlusses gespeist wird.

Gemäß einer Ausführungsform schaltet ein Auswertesignal einen Hilfskurzschluss ein.

Gemäß einer Ausführungsform kann die gesamte Schaltung, beispielsweise die Stromsensoranordnung, passiv oder aktiv ausgelegt werden.

Gemäß einer Ausführungsform kann eine passive Auslegung durch eine RC-Glied Integration und einfache Dioden oder durch eine einfache Verknüpfung realisiert werden.

Gemäß einer Ausführungsform kann eine aktive Auslegung eine Integration durch einen Operationsverstärker oder einen Mikroprozessor bzw. uP umfassen.

## Patentansprüche

1. Strommessanordnung mit einer ersten Messinduktivität (103), einer zweiten Messinduktivität (403, 503) und einer dritten Messinduktivität (405, 505), wobei die erste Messinduktivität
die folgenden Merkmale umfasst:
eine erste Messspule (105), welche planar ist und in einer ersten Ebene angeordnete Windungen aufweist;
eine zweite Messspule (107), welche planar ist und in einer zweiten Ebene angeordnete Windungen aufweist; wobei
die erste Messspule (105) und die zweite Messspule (107) elektrisch in Reihe verbunden sind, unterschiedliche Spuleneigenschaften aufweisen und über einen windungsfreien Abschnitt (109) elektrisch verbunden sind,
wobei die zweite Messinduktivität (403, 503) eine dritte planare Messspule mit ersten Windungen, welche in der ersten Ebene angeordnet sind, eine vierte planare Messspule mit zweiten Windungen, welche in der zweiten Ebene angeordnet sind, und einen windungsfreien Verbindungsabschnitt, welcher die dritte planare Messspule mit der vierten planaren Messspule elektrisch verbindet, umfasst, wobei die dritte Messinduktivität (405, 505) eine fünfte planare Messspule mit ersten Windungen, welche in der ersten Ebene angeordnet sind, eine sechste planare Messspule mit zweiten Windungen, welche in der zweiten Ebene angeordnet sind, und einen windungsfreien Verbindungsabschnitt, welcher die fünfte planare Messspule mit der sechsten planaren Messspule elektrisch verbindet, umfasst, und wobei die jeweilige Messinduktivität zur Erfassung eines Stroms in jeweils einem Strom führenden Leiter eines Mehrphasen-Leitersystems vorgesehen ist.

2. Strommessanordnung nach Anspruch 1, wobei die erste Messspule (105) und die zweite Messspule (107) unterschiedliche Induktivitäten, unterschiedliche Windungszahlen, unterschiedliche Flächen oder unterschiedliche Windungsdurchmesser aufweisen.

3. Strommessanordnung nach Anspruch 1 oder 2, wobei die ersten Windungen schneckenförmig oder spiralförmig in der ersten Ebene planar ausgebildet sind, und wobei die zweiten Windungen schneckenförmig oder spiralförmig in der zweiten Ebene planar ausgebildet sind.

4. Strommessanordnung nach Anspruch 3, wobei die erste Ebene und die zweite Ebene
parallel zueinander sind oder unter einem vorbestimmten Winkel zueinander verlaufen.

5. Strommessanordnung nach einem der vorstehenden Ansprüche, wobei die erste Messspule (105) und die zweite Messspule (107) in Reihe über einen ersten windungsfreien Verbindungsabschnitt verbunden sind, wobei ein Anschlussterminal mit einem ersten Messanschluss, welcher mit der ersten Messspule verbunden ist, und mit einem zweiten Messanschluss, welcher über einen zweiten windungsfreien Verbindungsabschnitt mit der zweiten Messspule verbunden ist, vorgesehen ist.

6. Strommessanordnung nach Anspruch 5, wobei der Strom führende Leiter oberhalb oder
unterhalb des jeweiligen wicklungsfreien Verbindungsabschnitts anordenbar ist.

7. Strommessanordnung nach einem der vorstehenden Ansprüche, die ferner dielektrisches Substrat, insbesondere eine Leiterplatte, umfasst, wobei die Messinduktivität auf oder in dem Substrat angeordnet ist, und wobei die erste Messspule und die zweite Messspule auf oder in dem Substrat gebildet sind.

8. Strommessanordnung nach einem der vorstehenden Ansprüche, wobei die erste planare Messspule und
die zweite planare Messspule beidseitig eines ersten Strom führenden Leiters des Mehrphasen-Leitersystems angeordnet sind, wobei die dritte planare Messspule und die vierte planare Messspule beidseitig eines zweiten Strom führenden Leiters des Mehrphasen-Leitersystems angeordnet sind, und wobei die fünfte planare Messspule und die sechste planare Messspule beidseitig eines dritten Strom führenden Leiters des Mehrphasen-Leitersystems angeordnet sind.

9. Strommessanordnung nach einem der vorstehenden Ansprüche, wobei die zweite planare
Messspule und die dritte planare Messspule nebeneinander in unterschiedlichen Abständen zu dem ersten Strom führenden Leiter oder zu dem zweiten Strom führenden Leiter angeordnet sind, und wobei die vierte planare Messspule und die fünfte planare Messspule nebeneinander in unterschiedlichen Abständen zu dem zweiten Strom führenden Leiter oder zu dem dritten Strom führenden Leiter angeordnet sind.

10. Strommessanordnung nach einem der vorstehenden Ansprüche, wobei die zweite Messinduktivität (503) bezüglich der Messinduktivität (501) und bezüglich der dritten Messinduktivität (505) lateral, insbesondere in Verlaufsrichtung des zweiten Strom führenden Leiters, versetzt ist.

11. Strommessanordnung nach Anspruch 10, wobei die dritte Messspule unmittelbar neben dem ersten Strom führenden Leiter und wobei die vierte Messspule unmittelbar neben dem dritten Strom führenden Leiter angeordnet sind.

12. Strommessanordnung nach einem der vorstehenden Ansprüche, wobei die Strom führenden
Leiter des Mehrphasen-Leitersystems durch die Ecken eines geometrischen Dreiecks verlaufen, und wobei die zweite Messinduktivität und die dritte Messinduktivität an den Ecken des planaren geometrischen Dreiecks angeordnet sind.

13. Strommessanordnung nach einem der vorstehenden Ansprüche, wobei die zweite planare Messspule einen geringeren Windungsdurchmesser oder weniger Windungen als die erste planare Messspule aufweist, wobei die vierte planare Messspule einen geringeren Windungsdurchmesser oder weniger Windungen als die dritte planare Messspule aufweist und wobei die sechste planare Messspule einen geringeren Windungsdurchmesser oder weniger Windungen als die fünfte planare Messspule aufweist.

14. Strommessanordnung nach einem der vorstehenden Ansprüche, wobei die jeweilige
Messinduktivität ausgebildet ist, ein Ausgangssignal, insbesondere eine Ausgangsspannung oder einen Ausgangsstrom, auszugeben, welches jeweils von einer Stromstärke in dem jeweiligen Strom führenden Leiter abhängig ist, wobei die Stromsensoranordnung ferner eine Überwachungseinrichtung umfasst, welcher ausgebildet ist, eine Überschreitung eines Stromschwellwertes durch einen elektrischen Strom in dem jeweiligen Strom führenden Leiter auf der Basis des Ausgangssignals der jeweiligen Messinduktivität zu überwachen.

15. Strommessanordnung nach Anspruch 14, wobei die Überwachungseinrichtung folgende Merkmale umfasst:
einen ersten Überwachungspfad zum Empfangen des Ausgangssignals der Messinduktivität mit einem ersten Schwellwertdetektor und einer dem ersten Schwellwertdetektor nachgeschalteten ersten Diode;
einen zweiten Überwachungspfad zum Empfangen des Ausgangssignals der zweiten Messinduktivität mit einem zweiten Schwellwertdetektor und einer dem zweiten Schwellwertdetektor nachgeschalteten zweiten Diode;
einen dritten Überwachungspfad zum Empfangen des Ausgangssignals der dritten Messinduktivität mit einem dritten Schwellwertdetektor und einer dem dritten Schwellwertdetektor nachgeschalteten dritten Diode; und
einem Steueranschluss, mit welchem die Kathode der ersten Diode, die Kathode der zweiten Diode und die Kathode der dritten Diode elektrisch verbunden sind;
wobei der jeweilige Schwellwertdetektor ausgebildet ist, bei Überschreitung eines Schwellwertes durch einen durch das jeweilige Ausgangssignal repräsentierten Strom einen Ausgangsstrom zu erzeugen.

16. Strommessanordnung nach Anspruch 15, mit einer Kurzschlusserzeugungseinrichtung, welche dem Steueranschluss nachgeschaltet und ausgebildet ist, ansprechend auf einen Ausgangsstrom am Steueranschluss zumindest einen der Strom führenden Leiter, insbesondere für ein vorbestimmtes Kurzschlussintervall, kurzzuschließen.

## Claims

1. Current sensor arrangement with a first measuring inductance (103), a second measuring inductance (403, 503) and a third measuring inductance (405, 505), wherein the first measuring inductance comprises the following features:
a first measuring coil (105) comprising windings which are planar and disposed in a first plane;
a second measuring coil (107) comprising windings which are planar and disposed in a second plane; wherein
the first measuring coil (105) and the second measuring coil (107) are electrically connected in series, have different coil properties and are electrically connected via a winding-free section (109),
wherein the second measuring inductance (403,503) comprises a third planar measuring coil having first windings which are disposed in a first plane, a fourth planar measuring coil having second windings which are disposed in a second plane and a winding-free connecting section which electrically connects the third planar measuring coil to the fourth planar measuring coil, wherein the third measuring inductance (405, 505) comprises a fifth planar measuring coil having first windings which are disposed in the first plane, a sixth planar measuring coil having second windings which are disposed in the second plane and a winding-free connecting section which electrically connects the fifth planar measuring coil to the sixth planar measuring coil, and wherein each measuring inductance is provided for detecting a current in one current-carrying conductor of a multi-phase conductor system at a time.

2. Current sensor arrangement according to claim 2, wherein the first measuring coil (105) and the second measuring coil (107) have different inductances, different numbers of windings, different areas or different winding diameters.

3. Current sensor arrangement according to claim 1 or 2, wherein the first windings are helically or helically formed planar in the first plane, and wherein the second windings are helically or helically formed planar in the second plane.

4. Current sensor arrangement according to claim 3, wherein the first plane and the second plane are oriented parallel to each other or at a predetermined angle to each other.

5. Current sensor arrangement according to one of the preceding claims, wherein the first measuring coil (105) and the second measuring coil (107) are connected in series via a first winding-free connection portion, wherein a connection terminal having a first measuring terminal, which is connected to the first measuring coil, and with a second measuring terminal, which is connected to the second measuring coil via a second winding-free connecting section.

6. Current sensor arrangement according to claim 5, wherein the current-carrying conductor is arrangeable above or below the respective winding-free connecting portion.

7. Current sensor arrangement according to one of the preceding claims, further comprising a dielectric substrate, in particular a printed circuit board, wherein the measuring inductance is arranged on or in the substrate, and wherein the first measuring coil and the second measuring coil are formed on or in the substrate.

8. Current sensor arrangement according to one of the preceding claims, wherein the first planar measuring coil and the second planar measuring coil are disposed on both sides of a first current-carrying conductor of the multiphase conductor system, wherein the third planar measuring coil and the fourth planar measuring coil are disposed on both sides of a second current-carrying conductor of the multi-phase conductive system, and wherein the fifth planar measuring coil and the sixth planar measuring coil are arranged on both sides of a third current-carrying conductor of the multi-phase conductor system.

9. Current sensor arrangement according to one of the preceding claims, wherein the second planar measuring coil and the third planar measuring coil are arranged side by side at different distances from the first current-carrying conductor or the second current-carrying conductor, and wherein the fourth planar measuring coil and the fifth planar measuring coil are arranged side by side at different distances to the second current-carrying conductor or to the third current-carrying conductor.

10. Current sensor arrangement according to one of the preceding claims, wherein the second measuring inductance (503) is offset laterally with respect to the first measuring inductance (501) and with respect to the third measuring inductance (505), in particular in the direction of the second current-carrying conductor.

11. Current sensor arrangement according to claim 10, wherein the third measuring coil is arranged directly next to the first current-carrying conductor and wherein the fourth measuring coil is arranged directly next to the third current-carrying conductor.

12. Current sensor arrangement according to one of the preceding claims, wherein the current-carrying conductors of the multiphase conductor system extend through the corners of a geometric triangle, and wherein the second measuring inductance and the third measuring inductance are arranged at the corners of the planar geometric triangle.

13. Current sensor arrangement according to one of the preceding claims, wherein the second planar measuring coil has a smaller winding diameter or fewer windings than the first planar measuring coil, wherein the fourth planar measuring coil has a smaller winding diameter or fewer windings than the third planar measuring coil and wherein the sixth planar measuring coil has a smaller winding diameter or fewer windings than the fifth planar measuring coil.

14. Current sensor arrangement according to one of the preceding claims, wherein the respective measuring inductance is configured to output an output signal, in particular an output voltage or an output current, which in each case is dependent on an amperage in the respective current-carrying conductor, wherein the current sensor arrangement further comprises a monitoring device which is configured to monitor an exceeding of a current threshold by an electric current in the respective current-carrying conductor on the basis of the output signal of the respective measuring inductance.

15. Current sensor arrangement according to claim 14, wherein the monitoring device comprises the following features:
a first monitoring path for receiving the output signal of the measuring inductance comprising a first threshold detector and a first diode which is connected downstream of the first threshold detector;
a second monitoring path for receiving the output signal of the second measuring inductor comprising a second threshold detector and a second diode which is connected downstream of the second threshold detector;
a third monitoring path for receiving the output signal of the third measuring inductor comprising a third threshold detector and a third diode which is connected downstream of the third threshold detector; and
a control terminal to which the cathode of the first diode, the cathode of the second diode and the cathode of the third diode are electrically connected; wherein the respective threshold detector is configured to generate an output current when a threshold is exceeded by a current represented by the respective output signal.

16. Current sensor arrangement according to claim 15, with a short-circuit generating device, which is connected downstream of the control terminal and configured to short circuit at least one of the current-carrying conductors, in particular for a predetermined short circuit interval, in response to an output current at the control terminal.

## Revendications

1. Dispositif de mesure de courant avec une première inductance de mesure (103), une deuxième inductance de mesure (403, 503) et une troisième inductance de mesure (405, 505), la première inductance de mesure comprenant les particularités suivantes :
une première bobine de mesure (105) qui est plane et présente des spires disposées dans un premier plan ;
une deuxième bobine de mesure (107) qui est plane et présente des spires disposées dans un deuxième plan ; dans lequel
la première bobine de mesure (105) et la deuxième bobine de mesure (107) sont connectées électriquement en série, présentent des propriétés de bobine différentes et sont reliées électriquement par une partie sans spires (109),
dans lequel la deuxième inductance de mesure (403, 503) comprend une troisième bobine de mesure plane avec des premières spires disposées dans le premier plan, une quatrième bobine de mesure plane avec des deuxièmes spires disposées dans le deuxième plan et une partie de liaison sans spires reliant électriquement la troisième bobine de mesure plane à la quatrième bobine de mesure, dans lequel la troisième inductance de mesure (405, 505) comprend une cinquième bobine de mesure plane avec des premières spires disposées dans le premier plan, une sixième bobine de mesure plane avec des deuxièmes spires disposées dans le deuxième plan et une partie de liaison sans spires reliant électriquement la cinquième bobine de mesure plane à la sixième bobine de mesure plane, et dans lequel l'inductance de mesure respective est prévue pour détecter un courant dans respectivement un conducteur porteur de courant d'un système de conducteurs polyphasé.

2. Dispositif de mesure de courant selon la revendication 1, dans lequel la première bobine de mesure (105) et la deuxième bobine de mesure (107) présentent des inductances différentes, des nombres de spires différents, des surfaces différentes ou des diamètres de spire différents.

3. Dispositif de mesure de courant selon la revendication 1 ou 2, dans lequel les premières spires sont réalisées de manière plane en forme d'hélice ou en forme de spirale dans le premier plan, et dans lequel les deuxièmes spires sont réalisées de manière plane en forme d'hélice ou en forme de spirale dans le deuxième plan.

4. Dispositif de mesure de courant selon la revendication 3, dans lequel le premier plan et le deuxième plan sont parallèles l'un à l'autre ou s'étendent selon un angle prédéterminé l'un par rapport à l'autre.

5. Dispositif de mesure de courant selon l'une quelconque des revendications précédentes, dans lequel la première bobine de mesure (105) et la deuxième bobine de mesure (107) sont reliées en série par l'intermédiaire d'une première partie de liaison sans spires, dans lequel une borne de connexion est prévue avec une première broche de mesure reliée à la première bobine de mesure et avec une deuxième broche de mesure reliée à la deuxième bobine de mesure par l'intermédiaire d'une deuxième partie de liaison sans spires.

6. Dispositif de mesure de courant selon la revendication 5, dans lequel le conducteur porteur de courant peut être disposé au-dessus ou au-dessous de la partie de liaison sans spires respective.

7. Dispositif de mesure de courant selon l'une quelconque des revendications précédentes, comprenant en outre un substrat diélectrique, en particulier un carte de circuits imprimés, dans lequel l'inductance de mesure est disposée sur ou dans le substrat, et dans lequel la première bobine de mesure et la deuxième bobine de mesure sont réalisées sur ou dans le substrat.

8. Dispositif de mesure de courant selon l'une quelconque des revendications précédentes, dans lequel la première bobine de mesure plane et la deuxième bobine de mesure plane sont disposées des deux côtés d'un premier conducteur porteur de courant du système de conducteurs polyphasé, dans lequel la troisième bobine de mesure plane et la quatrième bobine de mesure plane sont disposées des deux côtés d'un deuxième conducteur porteur de courant du système de conducteurs polyphasé, et dans lequel la cinquième bobine de mesure plane et la sixième bobine de mesure plane sont disposées des deux côtés d'un troisième conducteur porteur de courant du système de conducteurs polyphasé.

9. Dispositif de mesure de courant selon l'une quelconque des revendications précédentes, dans lequel la deuxième bobine de mesure plane et la troisième bobine de mesure plane sont disposées côte à côte avec des espacements différents par rapport au premier conducteur porteur de courant ou au deuxième conducteur porteur de courant, et dans lequel la quatrième bobine de mesure plane et la cinquième bobine de mesure plane sont disposées côte à côte avec des espacements différents par rapport au deuxième conducteur ou au troisième conducteur porteur de courant.

10. Dispositif de mesure de courant selon l'une quelconque des revendications précédentes, dans lequel la deuxième inductance de mesure (503) est décalée latéralement par rapport à l'inductance de mesure (501) et par rapport à la troisième inductance de mesure (505), en particulier dans la direction d'extension du deuxième conducteur porteur de courant.

11. Dispositif de mesure de courant selon la revendication 10, dans lequel la troisième bobine de mesure est disposée directement adjacente au premier conducteur porteur de courant et dans lequel la quatrième bobine de mesure est disposée directement adjacente au troisième conducteur porteur de courant.

12. Dispositif de mesure de courant selon l'une quelconque des revendications précédentes, dans lequel les conducteurs porteurs de courant du système de conducteurs polyphasé passe par les coins d'un triangle géométrique, et dans lequel la deuxième inductance de mesure et la troisième inductance de mesure sont disposées dans les coins du triangle géométrique plan.

13. Dispositif de mesure de courant selon l'une quelconque des revendications précédentes, dans lequel la deuxième bobine de mesure plane présente un diamètre de spire inférieur ou moins de spires que la première bobine de mesure plane, dans lequel la quatrième bobine de mesure plane présente un diamètre de spire inférieur ou moins de spires que la troisième bobine de mesure plane, et dans lequel la sixième bobine de mesure plane présente un diamètre de spire inférieur ou moins de spires que la cinquième bobine de mesure plane.

14. Dispositif de mesure de courant selon l'une quelconque des revendications précédentes, dans lequel l'inductance de mesure respective est réalisée pour sortir un signal de sortie, en particulier une tension de sortie ou un courant de sortie, qui dépend respectivement d'une intensité de courant dans le conducteur porteur de courant respectif, l'ensemble de capteur de courant comprenant en outre un dispositif de surveillance réalisé pour surveiller un dépassement d'une valeur seuil de courant par un courant électrique dans le conducteur porteur de courant respectif sur la base du signal de sortie de l'inductance de mesure respective.

15. Dispositif de mesure de courant selon la revendication 14, dans lequel le dispositif de surveillance comprend les particularités suivantes :
un premier trajet de surveillance pour recevoir le signal de sortie de l'inductance de mesure avec un premier détecteur de valeur seuil et une première diode connectée en aval du premier détecteur de valeur seuil ;
un deuxième trajet de surveillance pour recevoir le signal de sortie de la deuxième inductance de mesure avec un deuxième détecteur de valeur seuil et une deuxième diode connectée en aval du deuxième détecteur de valeur seuil ;
un troisième trajet de surveillance pour recevoir le signal de sortie de la troisième inductance de mesure avec un troisième détecteur de valeur seuil et une troisième diode connectée en aval du troisième détecteur de valeur seuil ; et
une broche de commande à laquelle la cathode de la première diode, la cathode de la deuxième diode et la cathode de la troisième diode sont connectées électriquement ;
le détecteur de valeur seuil respectif étant réalisé pour produire un courant de sortie en cas de dépassement de la valeur seuil par un courant représenté par le signal de sortie respectif.

16. Dispositif de mesure de courant selon la revendication 15, avec un dispositif destiné à créer un court-circuit, connecté en aval de la broche de commande et réalisé pour court-circuiter, en particulier pendant un intervalle de court-circuit prédéterminé, au moins l'un des conducteurs porteurs de courant en réponse à un courant de sortie à la borne de commande.
